# EUROPEAN PATENT APPLICATION

(11) **EP 4 757 543 A1**
(43) Date of publication of application: **10.06.2026**
(21) Application number: 25216536.0
(22) Date of filing: 18.11.2025
(51) Int. Cl.: H10F 39/00

(54) **IMAGE SENSOR, METHOD OF MANUFACTURING THE SAME, AND ELECTRONIC APPARATUS INCLUDING THE IMAGE SENSOR**

(30) Priority: 09.12.2024 KR 20240181953; 17.10.2025 KR 20250151014
(71) Applicant: Samsung Electronics Co., Ltd., Suwon-si, Gyeonggi-do 16677 (KR)
(72) Inventor: YOON, Yongseop, 16678 Suwon-si (KR); KIM, Jaekwan, 16678 Suwon-si (KR); LIM, Minwoo, 16678 Suwon-si (KR); PARK, Hongkyu, 16678 Suwon-si (KR)
(74) Representative: Elkington and Fife LLP

(57) **Abstract**

Provided is an image sensor including a sensor substrate including a plurality of sensing elements, an intermediate layer on the sensor substrate, an etch stop layer on the intermediate layer, and a nano-optical lens array on the etch stop layer, the nano-optical lens array including a plurality of nanostructures that are configured to collect incident light in the plurality of sensing elements, wherein the etch stop layer includes a transparent conductive material.

## Description

### FIELD OF THE INVENTION

Embodiments of the present disclosure relate to an image sensor, a method of manufacturing the image sensor, and an electronic apparatus including the image sensor.

### BACKGROUND OF THE INVENTION

In general, image sensors detect colors of incident light by using color filters. However, since color filters absorb colors of light other than their corresponding colors, light utilization efficiency may be decreased. For example, when a red-green-blue (RGB) color filter is used, only one-third of incident light is transmitted, while the remaining two-thirds are absorbed and discarded, resulting in a light utilization efficiency of only about 33 %. Accordingly, most of the light loss in color display apparatuses and color image sensors is caused by color filters.

### SUMMARY OF THE INVENTION

One or more embodiments provide an image sensor, an electronic apparatus including the image sensor, and a method of manufacturing the image sensor.

Additional aspects will be set forth in part in the description which follows and, in part, will be apparent from the description, or may be learned by practice of embodiments of the disclosure.

According to an aspect of one or more embodiments, there is provided an image sensor including a sensor substrate including a plurality of sensing elements, an intermediate layer on the sensor substrate, an etch stop layer on the intermediate layer, and a nano-optical lens array on the etch stop layer, the nano-optical lens array including a plurality of nanostructures that are configured to collect incident light in the plurality of sensing elements, wherein the etch stop layer includes a transparent conductive material.

There may thus be provided a CMOS image sensor including a meta structure with conductive and transparent etch stopper.

Embodiments may relate to an image sensor or a spectroscopic element structure (and its manufacture) to which a meta-photonic optical structure capable of spatially separating incident light according to wavelength is applied. There may be employed/provided an etch stopper using a conductive material for manufacturing a meta structure having various sub-micron-sized posts. Embodiments may be applicable to many different fields of applying a meta photonic optical structure in fabrication of conventional image sensors and spectroscopic elements.

According to an exemplary embodiment, there may be provided a meta-photonic optical element including a structure in which members having different refractive indices exist in a same layer, a member having a smaller refractive index surrounds a member having a greater refractive index, and a lower portion thereof is composed of a transparent and conductive material. The meta-photonic upper structure may include first members (posts) having a greater refractive index and a second member having a smaller refractive index surrounding the first members.

The transparent conductive material may include indium zinc oxide (IZO), indium gallium zinc oxide (IGZO), zinc oxide (ZnO) doped with a dopant, or a combination thereof.

According to another example, the transparent conductive material may include indium tin oxide (ITO).

The etch stop layer may have a thickness of 5 nm to 50 nm.

The etch stop layer may include a first etch stop layer and a second etch stop layer on the first etch stop layer, and the second etch stop layer may include indium tin oxide (ITO), indium zinc oxide (IZO), indium gallium zinc oxide (IGZO), zinc oxide (ZnO) doped with a dopant, or a combination thereof.

The first etch stop layer may include aluminum oxide (Al₂O₃), hafnium oxide (HfO₂), aluminum nitride (AIN), zinc oxide (ZnO), titanium oxide (TiO₂), zirconium oxide (ZrO₂), or a combination thereof.

A thickness of the intermediate layer may be greater than a thickness of the nano-optical lens array.

The nano-optical lens array may further include a dielectric layer on the plurality of nanostructures, and the dielectric layer may include a first material, the plurality of nanostructures include a second material, and a refractive index of the second material is greater than a refractive index of the first material.

The first material may include silicon oxide (SiO₂), hafnium oxide (HfO), or a combination thereof.

The second material may include titanium oxide (TiO₂), tantalum oxide (Ta₂O₃), zinc oxide (ZnO), or a combination thereof.

The image sensor may further include a color filter layer between the sensor substrate and the intermediate layer, the color filter layer including a plurality of color filters that are configured to transmit light of different colors.

The intermediate layer may include a planarization layer between the color filter layer and the nano-optical lens array and a sealing layer between the planarization layer and the nano-optical lens array, wherein the planarization layer may include an organic polymer material and the sealing layer may include an inorganic material.

According to another aspect of one or more embodiments, there is provided a method of manufacturing an image sensor, the method including preparing a sensor substrate including a plurality of sensing elements, providing an intermediate layer on the sensor substrate, providing an etch stop layer on the intermediate layer, providing a dielectric layer on the etch stop layer, providing a hard mask on the dielectric layer to etch a hole pattern in the dielectric layer, performing a dry etching process based on the hole pattern being provided, removing the hard mask after completing the etching of the dielectric layer, and providing a nano-optical lens array by forming a plurality of nanostructures through a chemical mechanical polishing (CMP) process, wherein the etch stop layer includes a transparent conductive material.

The transparent conductive material may include indium zinc oxide (IZO), indium gallium zinc oxide (IGZO), zinc oxide (ZnO) doped with a dopant, or a combination thereof.

According to another example, the transparent conductive material may include indium tin oxide (ITO).

The etch stop layer may have a thickness of 5 nm to 50 nm.

The etch stop layer may include a first etch stop layer and a second etch stop layer on the first etch stop layer, and the second etch stop layer may include indium tin oxide (ITO), indium zinc oxide (IZO), indium gallium zinc oxide (IGZO), zinc oxide (ZnO) doped with a dopant, or a combination thereof.

The first etch stop layer may include aluminum oxide (Al₂O₃), hafnium oxide (HfO₂), aluminum nitride (AIN), zinc oxide (ZnO), titanium oxide (TiO₂), zirconium oxide (ZrO₂), or a combination thereof.

According to yet another aspect of one or more embodiments, there is provided an electronic apparatus including an image sensor configured to convert optical images into electrical signals, and a processor configured to control operations of the image sensor, and store and output signals generated by the image sensor, wherein the image sensor includes an intermediate layer on a sensor substrate, an etch stop layer on the intermediate layer, and a nano-optical lens array on the etch stop layer, the nano-optical lens array including a plurality of nanostructures that are configured to collect incident light in the plurality of sensing elements, wherein the etch stop layer includes a transparent conductive material.

The transparent conductive material may include indium zinc oxide (IZO), indium gallium zinc oxide (IGZO), zinc oxide (ZnO) doped with a dopant, or a combination thereof.

According to another example, the transparent conductive material may include indium tin oxide (ITO).

The etch stop layer may have a thickness of 5 nm to 50 nm.

The etch stop layer may include a first etch stop layer and a second etch stop layer on the first etch stop layer, and the second etch stop layer includes indium tin oxide (ITO), indium zinc oxide (IZO), indium gallium zinc oxide (IGZO), zinc oxide (ZnO) doped with a dopant, or a combination thereof.

The first etch stop layer may include aluminum oxide (Al₂O₃), hafnium oxide (HfO₂), aluminum nitride (AIN), zinc oxide (ZnO), titanium oxide (TiO₂), zirconium oxide (ZrO₂), or a combination thereof.

### BRIEF DESCRIPTION OF DRAWINGS

The above and other aspects, features, and advantages of embodiments will be more apparent from the following description taken in conjunction with the accompanying drawings, in which:
FIG. 1 is a block diagram illustrating an image sensor according to one or more embodiments;
FIG. 2 is a view illustrating an example arrangement of pixels in a pixel array of an image sensor according to one or more embodiments;
FIGS. 3 and 4 are cross-sectional views schematically illustrating a configuration of a pixel array of an image sensor according to one or more embodiments;
FIGS. 5 and 6 are cross-sectional views schematically illustrating a configuration of a pixel array of an image sensor according to another embodiment;
FIGS. 7, 8, 9, 10, 11, 12, 13, 14, 15, and 16 are views schematically illustrating a method of manufacturing an image sensor, according to one or more embodiments;
FIG. 17 is a transmission electron microscope (TEM) image illustrating an example of the result of forming holes with different aspect ratios using an etching stop layer according to a related example;
FIG. 18 is a TEM image illustrating an example of the result of forming holes with different aspect ratios using an etch stop layer according to an embodiment;
FIGS. 19 and 20 are cross-sectional views schematically illustrating a configuration of a pixel array of an image sensor according to another embodiment;
FIG. 21 is a block diagram schematically illustrating an electronic apparatus including an image sensor, according to one or more embodiments;
FIG. 22 is a block diagram schematically illustrating a camera module included in the electronic apparatus shown in FIG. 21;
FIG. 23 is a block diagram illustrating an electronic apparatus including multiple camera modules; and
FIG. 24 is a view illustrating a camera module included in the electronic apparatus shown in FIG. 23.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, embodiments will be described with reference to the accompanying drawings. In the drawings, like reference numerals refer to like elements, and the sizes of elements may be exaggerated for clarity of illustration. The embodiments described herein are for illustrative purposes only, and various modifications may be made therein.

In the following description, when an element is referred to as being "above" or "on" another element, it may be directly on an upper, lower, left, or right side of the other element while making contact with the other element or may be above an upper, lower, left, or right side of the other element without making contact with the other element. The terms of a singular form may include plural forms unless otherwise mentioned. It will be further understood that the terms "comprises" and/or "comprising" used herein specify the presence of stated features or elements, but do not preclude the presence or addition of one or more other features or elements.

An element referred to with the definite article or a demonstrative determiner may be construed as the element or the elements even though it has a singular form. Operations of a method may be performed in an appropriate order unless explicitly described in terms of order or described to the contrary, and are not limited to the stated order thereof.

In the present disclosure, terms such as "unit" or "module" may be used to denote a unit that has at least one function or operation and is implemented with hardware, software, or a combination of hardware and software.

Furthermore, line connections or connection members between elements depicted in the drawings represent functional connections and/or physical or circuit connections by way of example, and in actual applications, they may be replaced or embodied with various additional functional connections, physical connections, or circuit connections.

Examples or exemplary terms are just used herein to describe technical ideas and should not be considered for purposes of limitation unless defined by the claims.

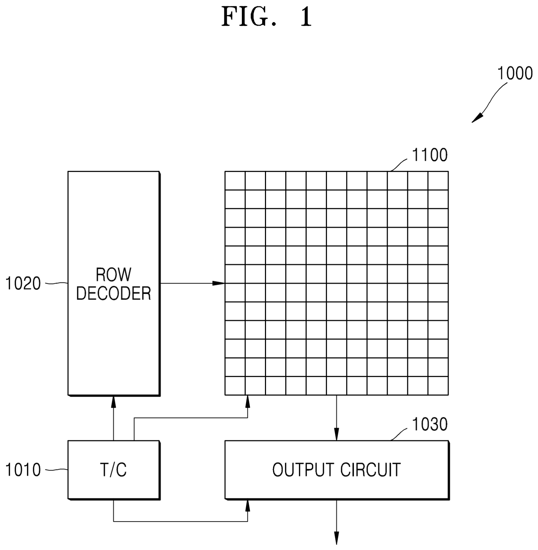

FIG. 1 is a block diagram illustrating an image sensor 1000 according to one or more embodiments.

Referring to FIG. 1, the image sensor 1000 may include a pixel array 1100, a timing controller 1010, a row decoder 1020, and an output circuit 1030. For example, the image sensor 1000 may be a charge-coupled device (CCD) image sensor or a complementary metal-oxide-semiconductor (CMOS) image sensor.

The pixel array 1100 may include pixels that are arranged two-dimensionally in a plurality of rows and a plurality of columns. The row decoder 1020 may select one of the rows of the pixel array 1100 in response to a row address signal that is output from the timing controller 1010. The output circuit 1030 may output photodetection signals in units of columns from a plurality of pixels arranged in the selected row. To this end, the output circuit 1030 may include a column decoder and an analog-to-digital converter (ADC). For example, the output circuit 1030 may include a plurality of ADCs arranged respectively for the columns between the column decoder and the pixel array 1100, or may include a single ADC provided at an output terminal of the column decoder. The timing controller 1010, the row decoder 1020, and the output circuit 1030 may be implemented on a single chip or separate chips. A processor for processing image signals output through the output circuit 1030 may also be implemented on the same chip together with the timing controller 1010, the row decoder 1020, and the output circuit 1030.

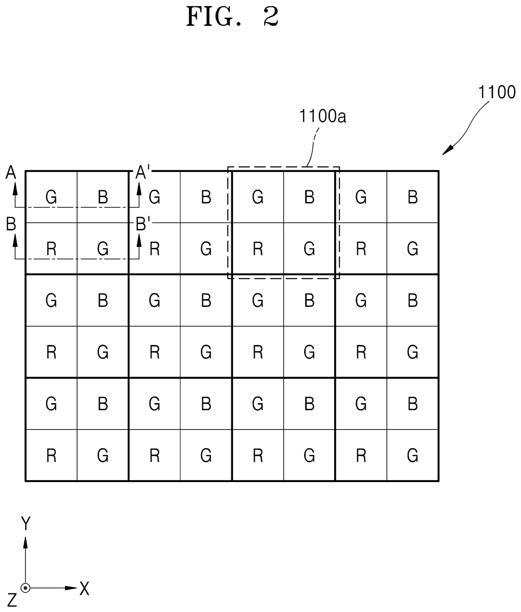

The pixel array 1100 may include a plurality of pixels configured to detect light of different wavelengths. The pixel arrangement of the pixel array 1100 may be implemented in various manners. For example, FIG. 2 illustrates a Bayer pattern, which is commonly employed in general image sensors.

Referring to FIG. 2, unit patterns 1100a may each include four quadrant regions, that is, first to fourth quadrant regions, and the first to fourth quadrant regions may be a blue pixel B, a green pixel G, a red pixel R, and a green pixel G, respectively. The unit patterns 1100a are repetitively arranged two-dimensionally in a first direction (X direction) and a second direction (Y direction). That is, in each of the unit patterns 1100a that has a 2×2 array form, two green pixels G are arranged in a diagonal direction, and one blue pixel B and one red pixel R are arranged in the other diagonal direction. Looking at the overall pixel arrangement of the pixel array 1100, a first row, in which a plurality of green pixels G and a plurality of blue pixels B are alternately arranged in the first direction, and a second row, in which a plurality of red pixels R and a plurality of green pixels G are alternately arranged in the first direction, are repeatedly arranged in the second direction. As another example, a first row, in which a plurality of green pixels G and a plurality of red pixels R are alternately arranged in the first direction, and a second row, in which a plurality of blue pixels B and a plurality of green pixels G are alternately arranged in the first direction, may be repeatedly arranged in the second direction. For ease of illustration, an example in which the pixel array 1100 has a Bayer pattern structure is described below. However, the following description is not limited thereto and may also be applied to pixel arrays having various pattern structures.

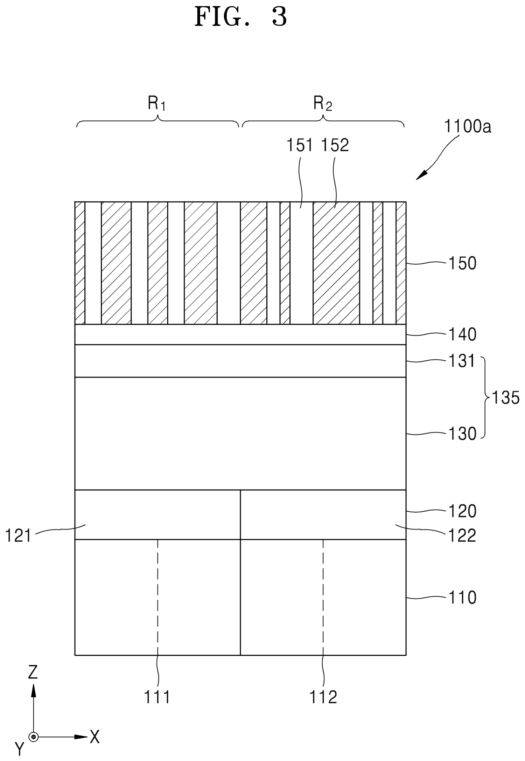

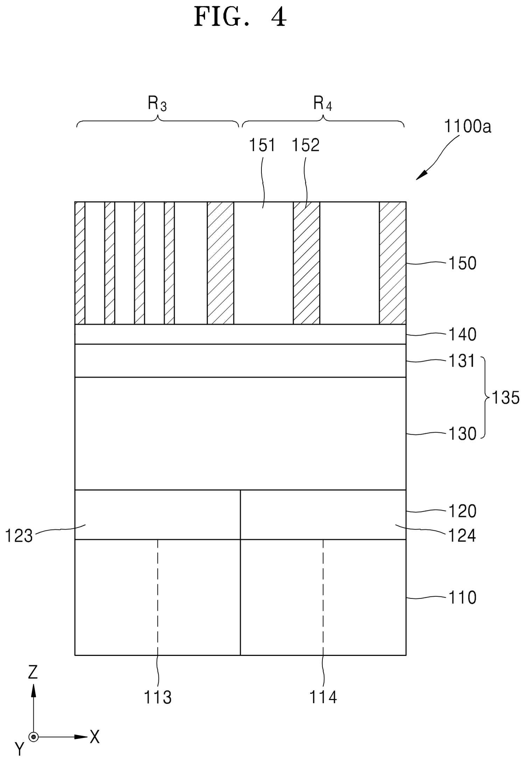

FIGS. 3 and 4 are cross-sectional views schematically illustrating a configuration of the pixel array 1100 of the image sensor 1000 according to one or more embodiments. FIG. 3 is a cross-sectional view taken along line A-A' of FIG. 2, and FIG. 4 is a cross-sectional view taken along line B-B' of FIG. 2. FIG. 3 illustrates a cross-section of a green pixel and a cross-section of a blue pixel, and FIG. 4 illustrates a cross-section of a red pixel and a cross-section of a green pixel.

Referring to FIGS. 3 and 4, the pixel array 1100 may include a sensor substrate 110, a planarization layer 130 that is transparent and disposed on the sensor substrate 110, an etch stop layer 140 disposed on the planarization layer 130, and a nano-optical lens array 150 disposed on the etch stop layer 140. Additionally, the pixel array 1100 may further include a color filter layer 120 between the sensor substrate 110 and the planarization layer 130, In addition, the pixel array 1100 may further include a sealing layer 131 between the planarization layer 130 and the etch stop layer 140. The planarization layer 130 and the sealing layer 131 may form an intermediate layer 135.

The sensor substrate 110 may include a plurality of sensing elements to detect incident light. For example, the sensor substrate 110 may include a first sensing element 111, a second sensing element 112, a third sensing element 113, and a fourth sensing element 114 to convert incident light into electrical signals for generating an image signal. The first sensing element 111, the second sensing element 112, the third sensing element 113, and the fourth sensing element 114 may form a unit Bayer pattern 1100a. For instance, the first sensing element 111 and the fourth sensing element 114 may be green-sensing elements configured to detect green light, the second sensing element 112 may be a blue-sensing element configured to detect blue light, and the third sensing element 113 may be a red-sensing element configured to detect red light.

Although FIGS. 3 and 4 illustrate, by example, one unit Bayer pattern 1100a including four sensing elements, the pixel array 1100 may include a plurality of Bayer patterns that are two-dimensionally arranged. For example, in a cross-section, a plurality of first sensing elements 111 and a plurality of second sensing elements 112 may be alternately arranged in the first direction (X direction), and in another cross-section positioned to be spaced apart from the cross-section in the second direction (Y direction) perpendicular to the first direction (X direction), a plurality of third sensing elements 113 and a plurality of fourth sensing elements 114 may be alternately arranged in the first direction (X direction).

Dotted lines in FIGS. 3 and 4 refer to boundaries between photodetection cells of the first to fourth sensing elements 111, 112, 113, and 114. Each of the first to fourth sensing elements 111, 112, 113, and 114 may include a plurality of photodetection cells that independently detect incident light. For example, each of the first to fourth sensing elements 111, 112, 113, and 114 may include first to fourth photodetection cells. For instance, in each of the first to fourth sensing elements 111, 112, 113, and 114, the first to fourth photodetection cells may be arranged in a 2×2 array form.

The color filter layer 120 may include a plurality of color filters each configured to transmit light of a specific wavelength and absorb light of other wavelengths. For example, the color filter layer 120 may include a first color filter 121 configured to transmit light of a first wavelength and absorb light of the other wavelengths, a second color filter 122 configured to transmit light of a second wavelength different from the first wavelength and absorb light of the other wavelengths, a third color filter 123 configured to transmit light of a third wavelength different from both the first and second wavelengths and absorb light of the other wavelengths, and a fourth color filter 124 configured to transmit light of the first wavelength and absorb light of the other wavelengths. FIGS. 3 and 4 illustrate one unit Bayer pattern 1100a as an example. However, in a cross-section, a plurality of first color filters 121 and a plurality of second color filters 122 may be alternately arranged in the first direction (X direction), and in another cross-section positioned to be spaced apart from the cross-section in the second direction (Y direction) perpendicular to the first direction (X direction), a plurality of third color filters 123 and a plurality of fourth color filters 124 may be alternately arranged in the first direction (X direction).

The first color filter 121 may face the first sensing element 111 in a third direction (Z direction), the second color filter 122 may face the second sensing element 112 in the third direction (Z direction), the third color filter 123 may face the third sensing element 113 in the third direction (Z direction), and the fourth color filter 124 may face the fourth sensing element 114 in the third direction (Z direction). Accordingly, the first sensing element 111 and the fourth sensing element 114 may detect light of the first wavelength that has passed through the first color filter 121 and the fourth color filter 124 respectively corresponding to the first sensing element 111 and the fourth sensing element 114. In addition, the second sensing element 112 may detect light of the second wavelength that has passed through the second color filter 122 corresponding to the second sensing element 112 The third sensing element 113 may detect light of the third wavelength that has passed through the third color filter 123 corresponding to the third sensing element 113. For example, the first color filter 121 and the fourth color filter 124 may be green color filters that transmit green light, the second color filter 122 may be a blue color filter that transmits blue light, and the third color filter 123 may be a red color filter that transmits red light. The first to fourth color filters 121, 122, 123, and 124 may include an organic polymer material.

For ease of illustration, FIGS. 3 and 4 illustrate that the color filter layer 120 has a flat upper surface. However, the upper surface of each of the first to fourth color filters 121, 122, 123, and 124 may not be flat. In addition, the first to fourth color filters 121, 122, 123, and 124, and a black matrix between the first to fourth color filters 121, 122, 123, and 124 may have different thicknesses in the third direction (Z direction). The planarization layer 130 disposed on the color filter layer 120 may provide a flat surface for forming the nano-optical lens array 150 above the flat surface. Furthermore, the planarization layer 130 may maintain a consistent spacing between the sensor substrate 110 and the nano-optical lens array 150. The planarization layer 130 may include a material that is transparent to visible light. For example, the planarization layer 130 may include siloxane-based spin-on glass (SOG), silicon oxide (SiO₂), silicon nitride (Si₃N₄), aluminum oxide (Al₂O₃), or an organic polymer material. The organic polymer material may include, for example, an epoxy resin, polyimide, polycarbonate, polyacrylate, polymethyl methacrylate (PMMA), or a combination thereof.

The sealing layer 131 may be further disposed on the planarization layer 130. The sealing layer 131 may operate as a diffusion barrier, preventing metal components of the color filter layer 120 from diffusing through the planarization layer 130 and being exposed externally due to relatively high temperatures during a process of forming the nano-optical lens array 150. To this end, the sealing layer 131 may include an inorganic material. The inorganic material of the sealing layer 131 may be formed at a temperature lower than a process temperature of a process of forming the nano-optical lens array 150 and may include a material that is transparent to visible light. In addition, the refractive index of the sealing layer 131 may be similar to the refractive index of the planarization layer 130 to reduce reflection loss at an interface between the planarization layer 130 and the sealing layer 131. For example, the sealing layer 131 may include an inorganic material such as SiO₂, SiN, silicon oxynitride (SiON), or a combination thereof.

The intermediate layer 135 comprising the planarization layer 130 and the sealing layer 131 may serve as a spacer that provides a distance between the sensor substrate 110 and the nano-optical lens array 150 such that light passing through the nano-optical lens array 150 may be focused on the sensor substrate 110. A thickness of the intermediate layer 135 in the third direction (Z direction) may be determined by the focal length of the nano-optical lens array 150. For example, a thickness of the planarization layer 130 in the third direction (Z direction) may be determined by the focal length of the nano-optical lens array 150 in a range of about 300 nm or more and about 5 µm or less. A thickness of the sealing layer 131 in the third direction (Z direction) may be smaller than the thickness of the planarization layer 130 in the third direction (Z direction). For example, the thickness of the sealing layer 131 in the third direction (Z direction) may be about 100 nm or more and about 500 nm or less. A thickness of the nano-optical lens array 150 in the third direction (Z direction) may be about 500 nm or more and about 1500 nm or less. The thickness of the intermediate layer 135 in the third direction (Z direction) may be greater than the thickness of the nano-optical lens array 150 in the third direction (Z direction) to secure a sufficient distance for incident light to be color-separated by the nano-optical lens array 150.

The nano-optical lens array 150 may include a first corresponding region R₁ corresponding to the first sensing element 111, a second corresponding region R₂ corresponding to the second sensing element 112, a third corresponding region R₃ corresponding to the third sensing element 113, and a fourth corresponding region R₄ corresponding to the fourth sensing element 114. For example, the first corresponding region R₁ may face the first sensing element 111 in the third direction (Z direction), the second corresponding region R₂ may face the second sensing element 112 in the third direction (Z direction), the third corresponding region R₃ may face the third sensing element 113 in the third direction (Z direction), and the fourth corresponding region R₄ may face the fourth sensing element 114 in the third direction (Z direction). FIGS. 3 and 4 illustrate only one unit pattern 1100a as an example. However, in a cross-section, a plurality of first corresponding regions R₁ and a plurality of second corresponding regions R₂ may be alternately arranged in the first direction (X direction), and in another cross-section positioned to be spaced apart from the cross-section in the second direction (Y direction) perpendicular to the first direction (X direction), a plurality of third corresponding regions R₃ and a plurality of fourth corresponding regions R₄ may be alternately arranged in the first direction (X direction).

Each of the first to fourth corresponding regions R₁, R₂, R₃, and R₄ may perform light collection and/or light color separation for a corresponding sensing element among the first to fourth sensing elements 111, 112, 113, and 114. For example, the first to fourth corresponding regions R₁, R₂, R₃, and R₄ of the nano-optical lens array 150 may collect and/or focus a first wavelength of incident light in the first sensing element 111 and the fourth sensing element 114, a second wavelength of the incident light in the second sensing element 112, and a third wavelength of the incident light in the third sensing element 113.

To this end, the first to fourth corresponding regions R₁, R₂, R₃, and R₄ may include a plurality of nanostructures 152 that are provided within a dielectric layer 151 to collect and/or focus light. Factors such as the shape, size (width and height), spacing, and arrangement pattern of the nanostructures 152 may be designed such that the first to fourth corresponding regions R₁, R₂, R₃, and R₄ may have a predetermined effective lens profile.

A region adjacent to and surrounding the nanostructures 152 may be filled with the dielectric layer 151, which has a lower refractive index than a refractive index of the nanostructures 152 and a relatively low absorption rate in a visible light band. The dielectric layer 151 may include a first material. The first material may have a refractive index greater than about 1 and less than about 2. For example, the first material may include SiO₂, hafnium oxide (HfO₂), or a combination thereof. The first material may be filled with, for example, PMMA, siloxane-based SOG, Si₃N₄, Al₂O₃, or air. The refractive index of the nanostructures 152 may be greater than or equal to about 2.0 for light of a wavelength of about 630 nm, and the refractive index of the dielectric layer 151 may range from about 1.0 to less than 2.0 for light of a wavelength of about 630 nm. Additionally, a difference between the refractive index of the nanostructures 152 and the refractive index of the dielectric layer 151 may be greater than or equal to about 0.5.

The nanostructures 152 may include a second material having a higher refractive index than the first material and a relatively low absorption rate in the visible light band. The second material may have a refractive index greater than 2.0. For example, the second material may include titanium oxide (TiO₂), tantalum oxide (Ta₂O₃), zinc oxide (ZnO), or a combination thereof. The second material may include c-Si, p-Si, a-Si, a Group III-V compound semiconductor (for example, gallium phosphide (GaP), gallium nitride (GaN), or gallium arsenide (GaAs)), silicon carbide (SiC), SiN₃, zinc sulfide (ZnS), zinc selenide (ZnSe), Si₃N₄, or a combination thereof.

The nanostructures 152 may have a size smaller than the wavelength of visible light. For example, the nanostructures 152 may have a size smaller than the wavelength of blue light. For instance, the nanostructures 152 may a cross-sectional width (or diameter) less than 400 nm, 300 nm, or 200 nm in the first direction and/or second direction (X direction and/or Y direction). The nanostructures 152 may have a height of about 500 nm to about 1500 nm, and the height of the nanostructures 152 in the third direction (Z direction) may be greater than the cross-sectional width of the nanostructures 152 in the first direction and/or second direction (X direction and/or Y direction).

The nanostructures 152, having a refractive index different from the refractive index of a surrounding material, may modify the phase of light passing through the nanostructures 152 based on phase delay caused by a subwavelength shape dimension of the nanostructures 152. The degree of phase delay may be determined by factors such as the shape dimensions and arrangement of the nanostructures 152. Due to the arrangement of the nano-optical lens array 150, the mode of color separation and light collection performed by the nano-optical lens array 150 may vary depending on the colors of sensing elements of the sensor substrate 110 facing the nano-optical lens array 150.

The etch stop layer 140 may include a transparent conductive material. The etch stop layer 140 may include a transparent conductive oxide (TCO). The TCO may include an amorphous transparent conductive material and a crystalline transparent conductive material. For example, the amorphous transparent conductive material may include indium zinc oxide (IZO), indium gallium zinc oxide (IGZO), zinc oxide (ZnO) doped with a dopant, or a combination thereof. The crystalline transparent conductive material may include indium tin oxide (ITO). Therefore, the etch stop layer 140 may include ITO, IZO, IGZO, ZnO doped with a dopant, or a combination thereof. ZnO doped with a dopant may include, for example, ZnO doped with aluminum (Al). The etch stop layer 140 may have a thickness of about 5 nm to about 50 nm in the third direction (Z direction). As another example, the etch stop layer 140 may have a thickness of about 5 nm to about 30 nm.

When the dielectric layer 151 includes a material such as SiO₂, the dielectric layer 151 may be etched by an etching gas including fluorine (for example, fluoromethylene (CHF₃) or carbon tetrafluoride (CF₄)) during a dry etching process of the dielectric layer 151. Even in this case, however, the etch stop layer 140 may not be etched, thereby improving the etch selectivity of the dielectric layer 151. The etch stop layer 140 may protect layers provided below the dielectric layer 151 when the dielectric layer 151 is etched to form the nano-optical lens array 150 above the planarization layer 130.

In addition, during a dry etching process of the dielectric layer 151 for forming the nano-optical lens array 150, cations (for example, CF⁺, CF²⁺, CF³⁺, or Ar⁺) may accumulate in holes having a relatively small width-to-depth ratio and may thus insufficiently reach bottoms of the holes compared to holes having a relatively large width-to-depth ratio. As a result, the rate of etching may decrease. Therefore, the etch stop layer 140 including a transparent conductive material is provided under the dielectric layer 151 to reduce the accumulation of cations in holes having a relatively small width-to-depth ratio. As a result, variations in the etching rate that occur depending on the aspect ratios of etched holes may be decreased, and over-etching in holes having a relatively large width-to-depth ratio may be prevented.

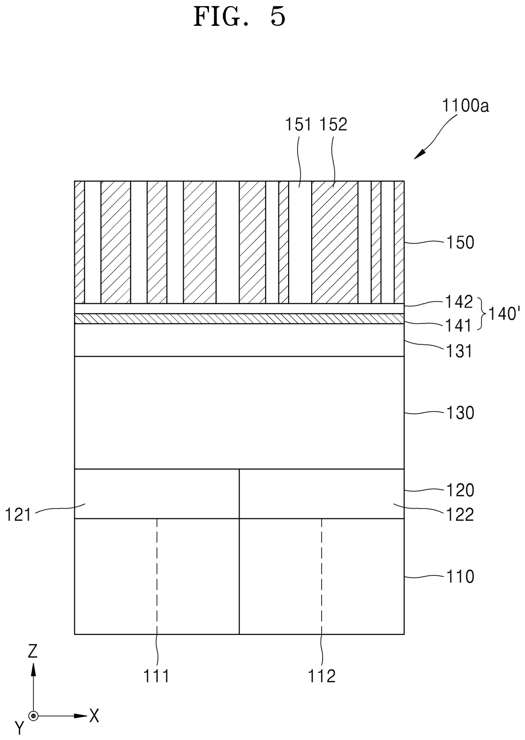

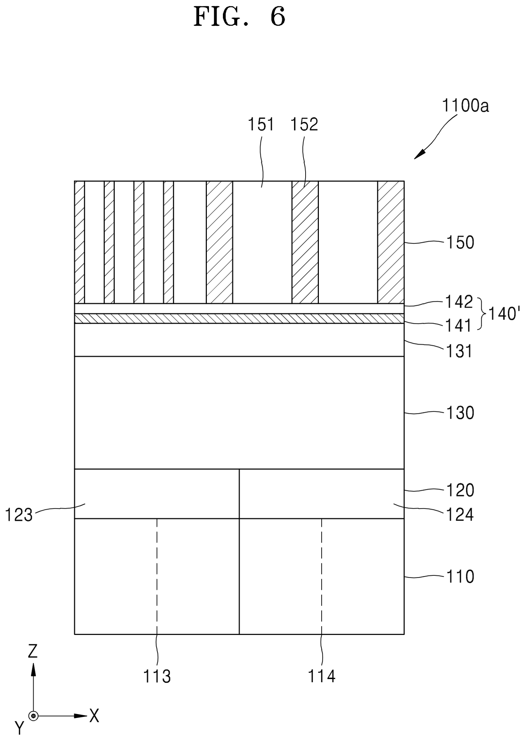

FIGS. 5 and 6 are cross-sectional views schematically illustrating a configuration of a pixel array 1100a of an image sensor according to one or more other embodiments. Differences from the embodiment described with reference to FIGS. 3 and 4 will now be mainly described, and in FIGS. 3 to 6, like reference numerals denote like elements.

Referring to FIGS. 5 and 6, a two-layered etch stop layer 140' may be provided. The two-layered etch stop layer 140' may include a first etch stop layer 141 and a second etch stop layer 142 provided on the first etch stop layer 141. The second etch stop layer 142 may be the same as the etch stop layer 140 described with reference to FIGS. 3 and 4. That is, the second etch stop layer 142 may include a transparent conductive material such as ITO, IZO, IGZO, ZnO doped with a dopant, or a combination thereof. The second etch stop layer 142 may have a thickness of about 5 nm to about 50 nm. Alternatively, the second etch stop layer 142 may have a thickness of about 5 nm to about 30 nm.

The first etch stop layer 141 may include Al₂O₃, HfO₂, aluminum nitride (AIN), ZnO, TiO₂, zirconium oxide (ZrO₂), or a combination thereof. The first etch stop layer 141 may have a thickness of about 5 nm to about 50 nm in the third direction (Z direction). As another example, the first etch stop layer 141 may have a thickness of about 5 nm to about 30 nm. When materials other than SiO₂ are etched using a material such as chlorine (Cl₂) gas in a dry etching process for forming a nano-optical lens array 150, the first etch stop layer 141 provided below the second etch stop layer 142 may prevent lower layers from being damaged even when the second etch stop layer 142 is damaged.

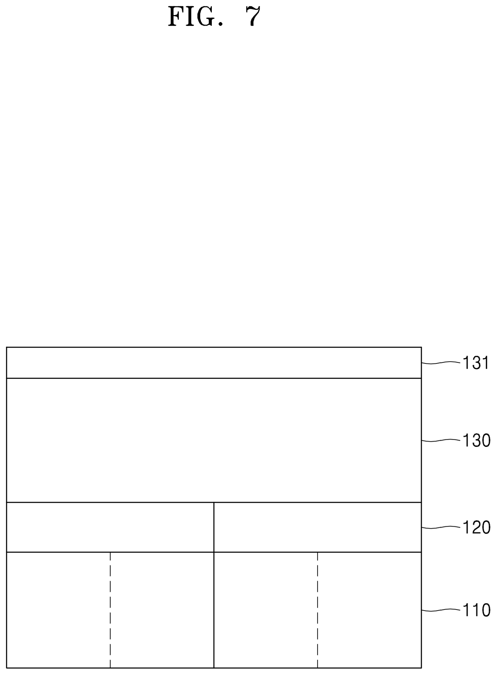

FIGS. 7 to 16 are views schematically illustrating a method of manufacturing an image sensor according to one or more embodiments. The image sensor manufacturing method will now be described with reference to FIGS. 7 to 16 together with FIGS. 3 to 6, and in the drawings, like reference numerals denote like elements.

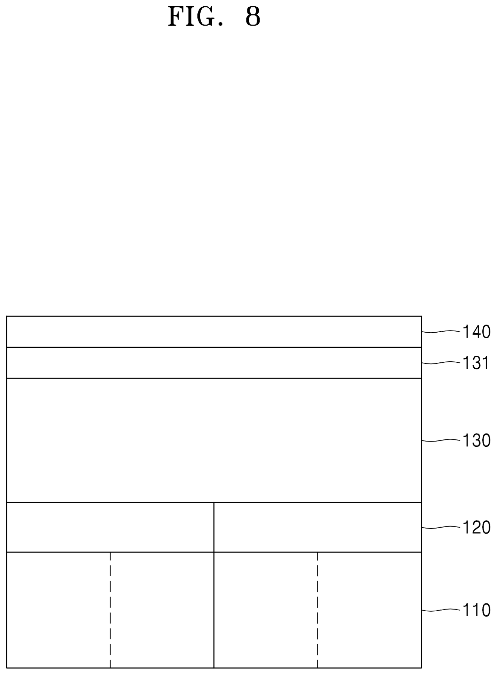

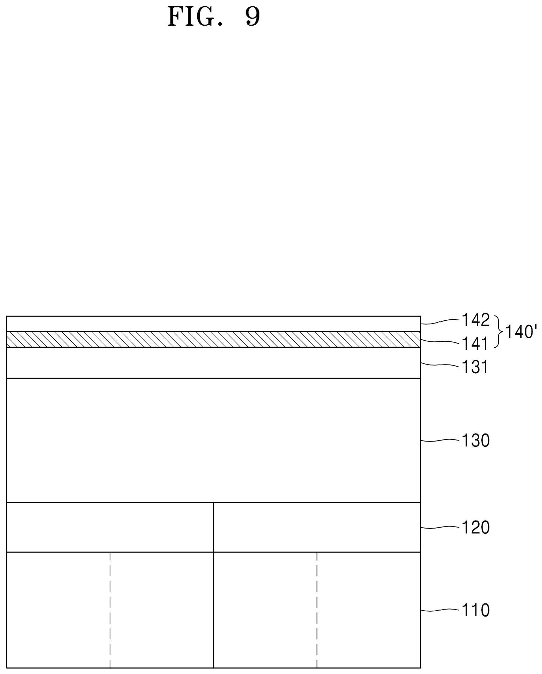

Referring to FIG. 7, a color filter layer 120 is provided on a sensor substrate 110, a planarization layer 130 is provided on the color filter layer 120, and a sealing layer 131 is provided on the planarization layer 130. The color filter layer 120 and the sealing layer 131 may be omitted. Then, referring to FIG. 8, an etch stop layer 140 is provided on the sealing layer 131 (or on the planarization layer 130 when the sealing layer 131 is omitted). The etch stop layer 140 may be deposited, for example, using a sputtering process. At this time, referring to FIG. 9, a two-layered etch stop layer 140' may be deposited by stacking a first etch stop layer 141 and a second etch stop layer 142 on the sealing layer 131.

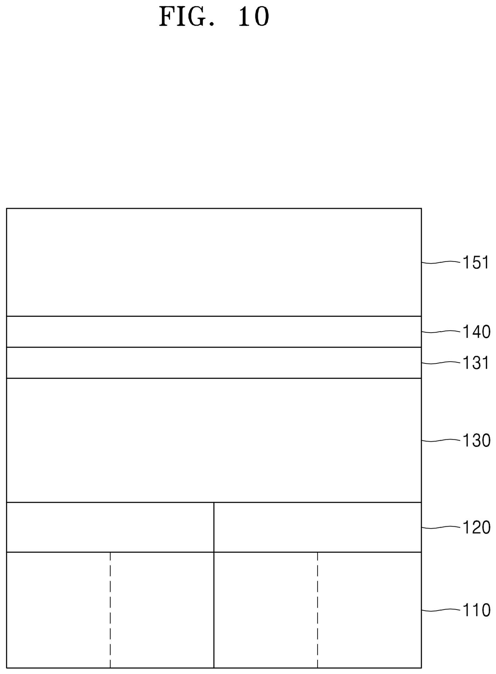

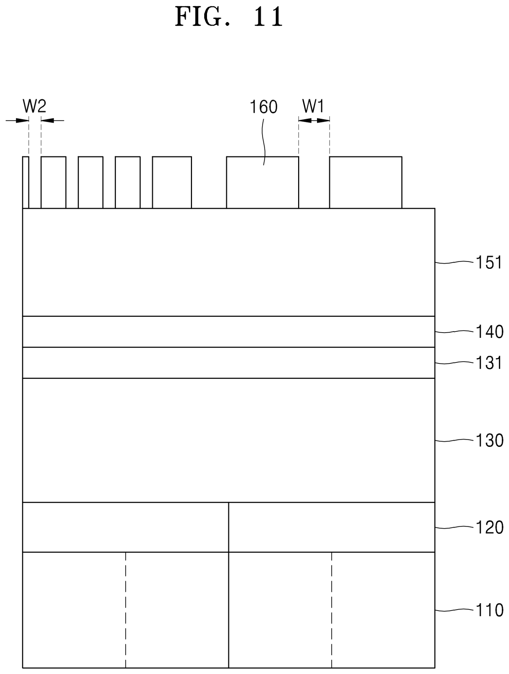

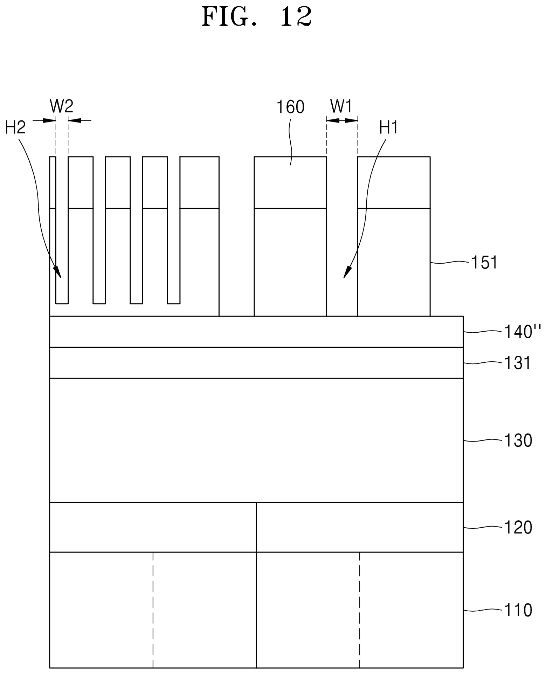

Then, referring to FIG. 10, a dielectric layer 151 is deposited on the etch stop layer 140. Referring to FIG. 11, a hard mask 160 for etching the dielectric layer 151 is provided on the dielectric layer 151, a hole pattern is formed, and a dry etching process is performed. At this time, as shown in FIG. 12, when a layer 140", which does not include a transparent conductive material, is provided under the dielectric layer 151 instead of the etch stop layer 140, and the width W1 of a first hole H1 is greater than the width W2 of a second hole H2 in the first direction and/or the second direction (X direction and/or Y direction), the etching of the second hole H2 may not be completed even after the etching of the first hole H1 is completed during the dry etching process because of different etching rates caused by the different aspect ratios of the first and second holes H1 and H2. During the dry etching process, cations accumulate in holes having a relatively small width-to-depth ratio, and thus, cations may not sufficiently reach the bottoms of the holes having a relatively small width-to-depth ratio.

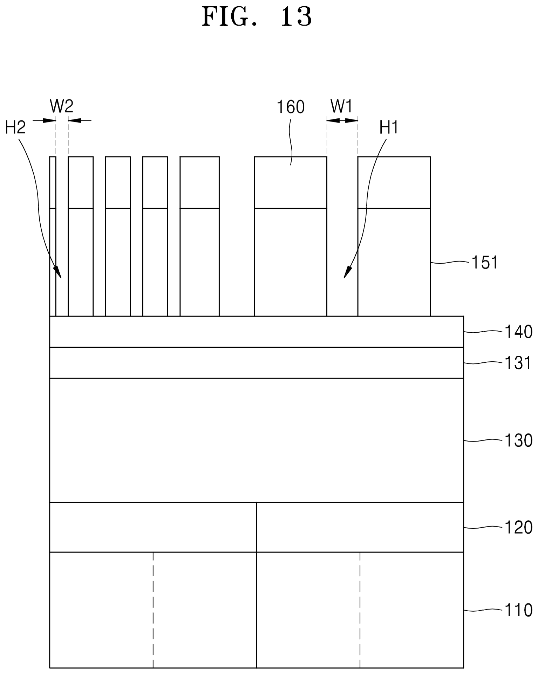

Therefore, as shown in FIG. 13, the etch stop layer 140 including a transparent conductive material is provided under the dielectric layer 151 to reduce cation accumulation in etched holes. As a result, etching rate variations caused by different aspect ratios of holes may be reduced, and over-etching may be prevented in holes with a large width-to-depth ratio.

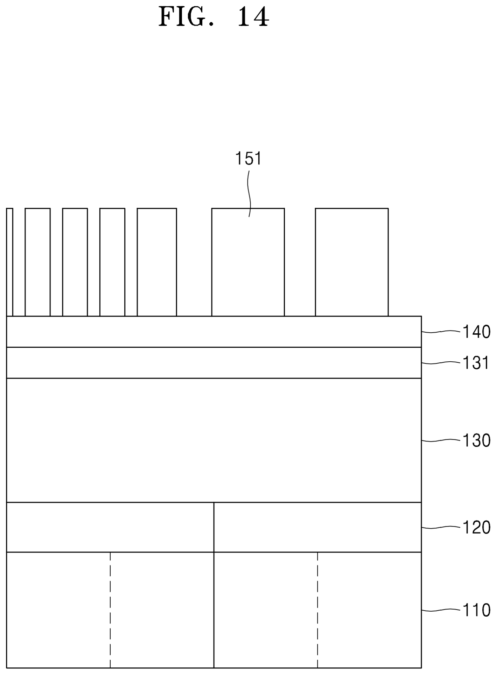

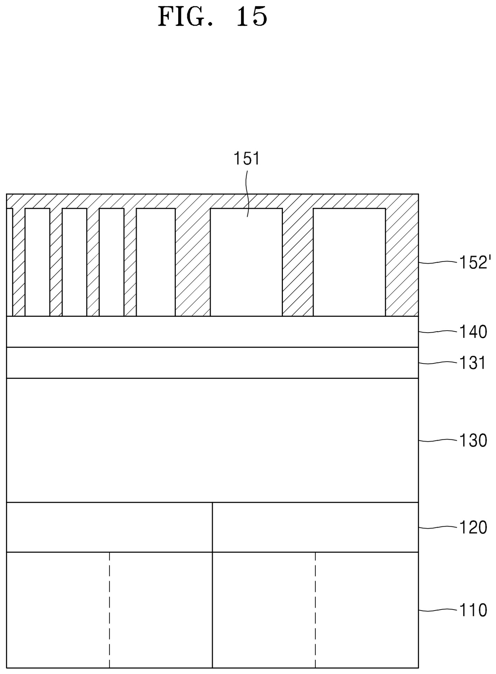

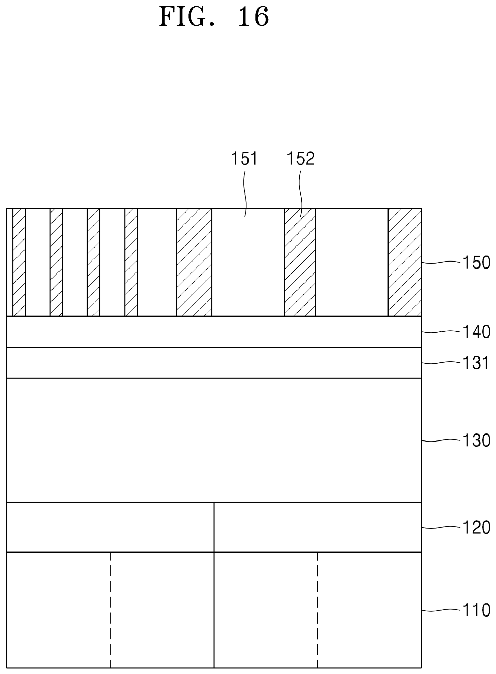

Then, referring to FIG. 14, after completing the etching of the dielectric layer 151, the hard mask 160 may be removed from the dielectric layer 151. Referring to FIG. 15, a second material 152' may be deposited on the dielectric layer 151. The second material 152' may be deposited, for example, using an atomic layer deposition (ALD) process. Referring to FIG. 16, a chemical mechanical polishing (CMP) process may be performed on the second material 152' to form a plurality of nanostructures 152, thereby completing the manufacture of a nano-optical lens array 150.

According to the image sensor manufacturing method of one or more embodiments, the nano-optical lens array 150 may be manufactured through simple processes, and process costs may be more effectively reduced.

The image sensor 1000 of one or more embodiments may form a camera module together with various types of lens modules and may be applied to various electronic apparatuses.

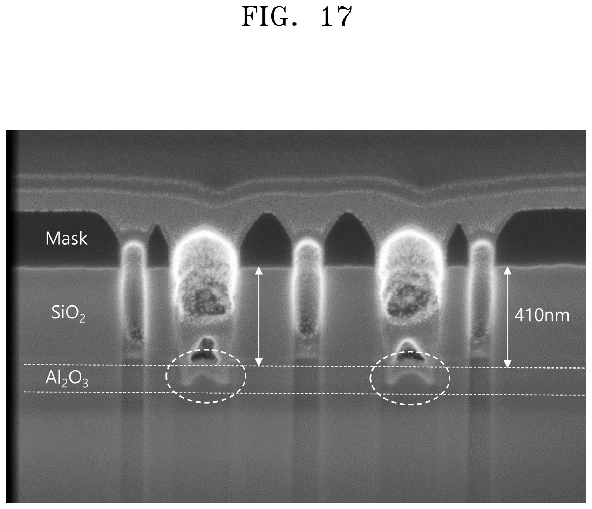

FIG. 17 is a transmission electron microscope (TEM) image illustrating an example of the result of forming holes with different aspect ratios using an etching stop layer according to a related example. Referring to FIG. 17, when holes with different aspect ratios are formed in SiO₂ by dry etching using Al₂O₃ as an etch stop layer, a difference in etching rates is observed in holes with different aspect ratios. Therefore, when dry etching is performed until a hole having a relatively large aspect ratio penetrates the SiO₂, the etch stop layer may be damaged due to over-etching in a hole having a relatively small aspect ratio, as indicated by the dotted circle. As a result, a depth of the hole having the relatively small aspect ratio may be greater than a depth of the hole having the relatively large aspect ratio.

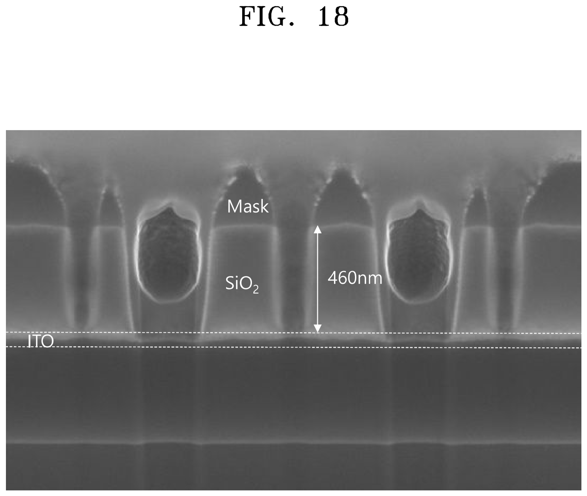

FIG. 18 is a TEM image illustrating an example of the result of forming holes with different aspect ratios using an etch stop layer according to an embodiment. Referring to FIG. 18, when holes with different aspect ratios are formed in SiO₂ by dry etching using ITO as an etch stop layer, the etching rates may be nearly uniform in the holes with different aspect ratios. Therefore, the holes with different aspect ratios may be formed with uniform depth in a single dry etching process.

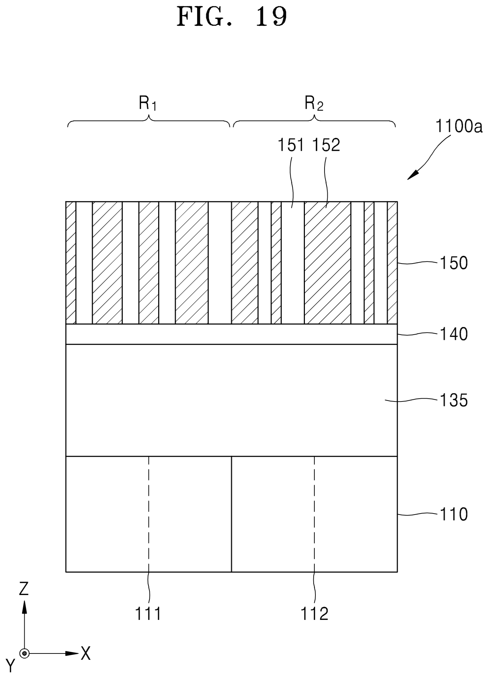

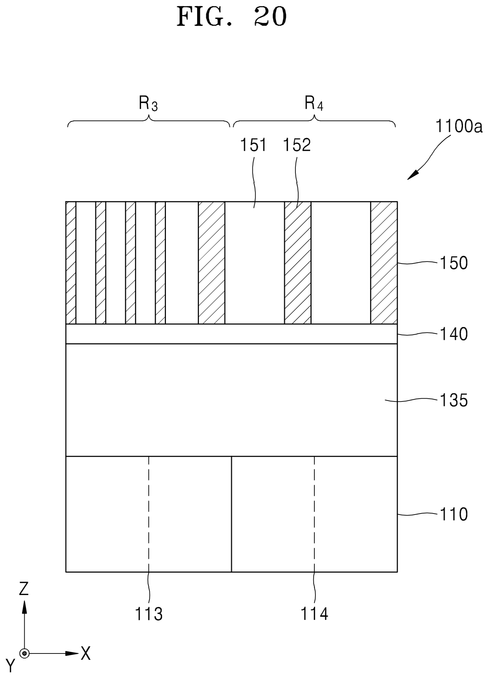

FIGS. 19 and 20 are cross-sectional views schematically illustrating a configuration of a pixel array of an image sensor according to another embodiment. Referring to FIGS. 19 and 20, when the nano-optical lens array 150 separates incident light with sufficient color purity, the color filter layer 120 may be omitted. When the color filter layer 120 is omitted, the intermediate layer 135 may be formed as a single layer. Accordingly, the intermediate layer 135 may be directly provided on the sensor substrate 110, the etch stop layer 140 may be directly provided on the intermediate layer 135, and the nano-optical lens array 150 may be directly provided on the etch stop layer 140.

The intermediate layer 135 may include only one material among the material of the planarization layer 130 and the material of the sealing layer 131. For example, the intermediate layer 135 may include siloxane-based spin-on glass (SOG), SiO₂, Si₃N₄, Al₂O₃, SiON, epoxy resin, polyimide, polycarbonate, polyacrylate, PMMA, or a combination thereof. The thickness of the intermediate layer 135 in the third direction (Z direction) may be determined according to the focal length of the nano-optical lens array 150 in a range of about 5.5 µm or less, and may be greater than the thickness of the nano-optical lens array 150 in the third direction (Z direction) in order to secure a sufficient distance for color separation by the nano-optical lens array 150.

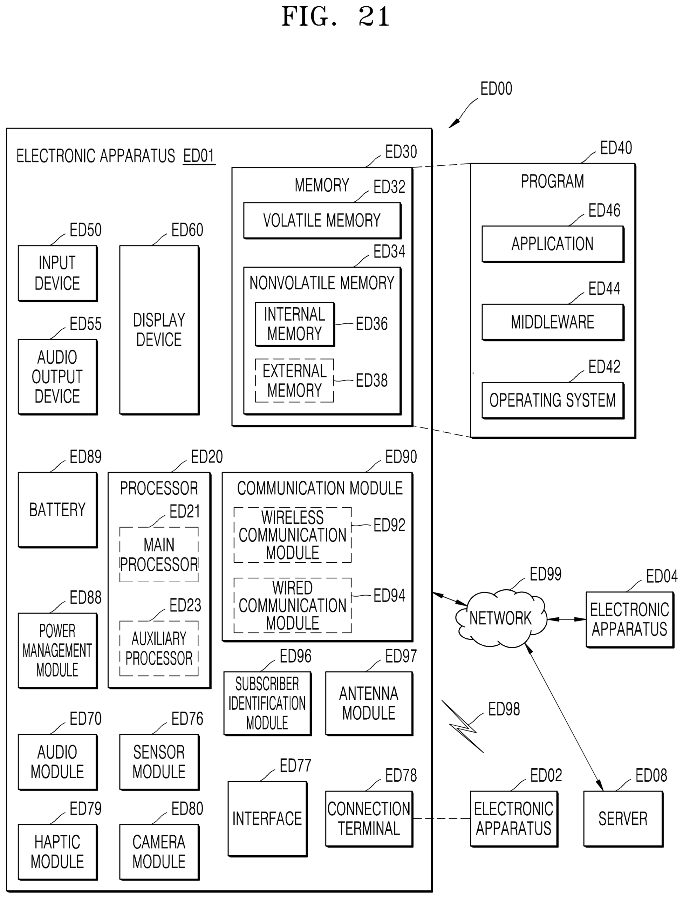

FIG. 21 is a block diagram illustrating a schematic structure of an electronic apparatus ED01 including the image sensor 1000 according to one or more embodiments. Referring to FIG. 21, in a network environment ED00, the electronic apparatus ED01 may communicate with another electronic apparatus ED02 through a first network ED98 (a near-field wireless communication network or the like) or may communicate with another electronic apparatus ED04 and/or a server ED08 through a second network ED99 (a far-field wireless communication network or the like). The electronic apparatus ED01 may communicate with the electronic apparatus ED04 through the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. Some (the display device ED60 or the like) of the components may be omitted from the electronic apparatus ED01, or other components may be added to the electronic apparatus ED01. Some of the components may be implemented in one integrated circuit. For example, the sensor module ED76 (a fingerprint sensor, an iris sensor, an illuminance sensor, or the like) may be embedded in the display device ED76 (a display or the like).

The processor ED20 may execute software (a program ED40 or the like) to control one or more other components (hardware or software components, or the like) of the electronic apparatus ED01 connected to the processor ED20, and may perform a variety of data processing or operations. As a portion of the data processing or operations, the processor ED20 may load instructions and/or data received from other components (the sensor module ED76, the communication module ED90, or the like) into a volatile memory ED32, process the instructions and/or data stored in the volatile memory ED32, and store result data in a nonvolatile memory ED34. The processor ED20 may include a main processor ED21 (a central processing unit, an application processor, or the like) and an auxiliary processor ED23 (a graphics processing unit, an image signal processor, a sensor hub processor, a communication processor, or the like), which is operated independently or together with the main processor ED21. The auxiliary processor ED23 may consume less power than the main processor ED21 and may perform specialized functions.

The auxiliary processor ED23 may control functions and/or states related to some (the display device ED60, the sensor module ED76, the communication module ED90, or the like) of the components of the electronic apparatus ED01 on behalf of the main processor ED21 while the main processor ED21 is in an inactive (e.g., sleep) state or together with the main processor ED21 while the main processor ED21 is in an active (e.g., application execution) state. The auxiliary processor ED23 (an image signal processor, a communication processor, or the like) may be implemented as a portion of other functionally relevant components (the camera module ED80, the communication module ED90, or the like).

The memory ED30 may store a variety of data required by the components (the processor ED20, the sensor module ED76, or the like) of the electronic apparatus ED01. The data may include, for example, software (the program ED40 or the like) and input data and/or output data for commands related thereto. The memory ED30 may include the volatile memory ED32 and/or the nonvolatile memory ED34.

The program ED40 may be stored as software in the memory ED30, and may include an operating system ED42, middleware ED44, and/or an application ED46.

The input device ED50 may receive commands and/or data to be used for the components (the processor ED20 or the like) of the electronic apparatus ED01 from the outside (a user or the like) of the electronic apparatus ED01. The input device ED50 may include a microphone, a mouse, a keyboard, and/or a digital pen (a stylus pen or the like).

The audio output device ED55 may output an audio signal to the outside of the electronic apparatus ED01. The audio output device ED55 may include a speaker and/or a receiver. The speaker may be used for general purposes such as multimedia playback or record playback, and the receiver may be used to receive incoming calls. The receiver may be provided as a portion of the speaker or may be implemented as a separate device.

The display device ED60 may visually provide information to the outside of the electronic apparatus ED01. The display device ED60 may include a display, a hologram device, or a projector, and a control circuit for controlling devices. The display device ED60 may include touch circuitry set to sense a touch, and/or sensor circuitry (a pressure sensor or the like) configured to measure the intensity of force generated by the touch.

The audio module ED70 may convert sound into an electrical signal, and vice versa. The audio module ED70 may obtain sound through the input device ED50, or may output sound through the audio output device ED55 and/or speakers and/or headphones of another electronic apparatus (the electronic apparatus ED02 or the like) directly or wirelessly connected to the electronic apparatus ED01.

The sensor module ED76 may detect an operating state (power, temperature, or the like) of the electronic apparatus ED01 or an external environmental state (user status or the like), and may generate an electrical signal and/or a data value corresponding to the detected state. The sensor module ED76 may include a gesture sensor, a gyro sensor, a barometric sensor, a magnetic sensor, an acceleration sensor, a grip sensor, a proximity sensor, a color sensor, an infrared (IR) sensor, a biological sensor, a temperature sensor, a humidity sensor, and/or an illuminance sensor.

The interface ED77 may support one or more designated protocols, which may be used to directly or wirelessly connect the electronic apparatus ED01 with other electronic apparatuses (the electronic apparatus ED02 or the like). The interface ED77 may include a high definition multimedia interface (HDMI), a universal serial bus (USB) interface, a secure digital (SD) card interface, and/or an audio interface.

A connection terminal ED78 may include a connector through which the electronic apparatus ED01 may be physically connected to other electronic apparatuses (the electronic apparatus ED02 or the like). The connection terminal ED78 may include an HDMI connector, a USB connector, an SD card connector, and/or an audio connector (a headphone connector or the like).

The haptic module ED79 may convert an electrical signal into a mechanical stimulus (vibration, movement, or the like) or an electrical stimulus that a user may perceive through tactile sensation or kinesthesia. The haptic module ED79 may include a motor, a piezoelectric element, and/or an electric stimulation device.

The camera module ED80 may capture a still image and a moving image. The camera module ED80 may include a lens assembly having one or more lenses, the image sensor 1000 shown in FIG. 1, an image signal processor, and/or a flash. The lens assembly included in the camera module ED80 may collect and/or focus light coming from an object to be imaged.

The power management module ED88 may manage power supplied to the electronic apparatus ED01. The power management module ED88 may be implemented as a portion of a power management integrated circuit (PMIC).

The battery ED89 may supply power to components of the electronic apparatus ED01. The battery ED89 may include a non-rechargeable primary battery, a rechargeable secondary battery, and/or a fuel cell.

The communication module ED90 may support establishment of a direct (wired) communication channel and/or a wireless communication channel between the electronic apparatus ED01 and other electronic apparatuses (the electronic apparatus ED02, the electronic apparatus ED04, the server ED08, or the like), and communication through the established communication channel. The communication module ED90 operates independently of the processor ED20 (an application processor or the like) and may include one or more communication processors supporting direct communication and/or wireless communication. The communication module ED90 may include a wireless communication module ED92 (a cellular communication module, a short-range wireless communication module, a global navigation satellite system (GNSS), or the like) and/or a wired communication module ED94 (a local area network (LAN) communication module, a power line communication module, or the like). A corresponding communication module from among these communication modules may communicate with other electronic apparatuses through the first network ED98 (a local area network such as Bluetooth, WiFi Direct, or IR data association (IrDA)) or the second network ED99 (a telecommunication network such as a cellular network, the Internet, or computer networks (LAN, WAN, or the like)). These various types of communication modules may be integrated into a single component (a single chip or the like) or may be implemented as a plurality of separate components (multiple chips). The wireless communication module ED92 may identify and authenticate the electronic apparatus ED01 within a communication network such as the first network ED98 and/or the second network ED99 using subscriber information (an international mobile subscriber identifier (IMSI) or the like) stored in the subscriber identification module ED96.

The antenna module ED97 may transmit and/or receive signals and/or power to and/or from the outside (other electronic apparatuses or the like). An antenna may include a radiator made of a conductive pattern formed on a substrate (a PCB or the like). The antenna module ED97 may include one or more such antennas. When a plurality of antennas are included in the antenna module ED97, the communication module ED90 may select an antenna suitable for a communication method used in a communication network, such as the first network ED98 and/or the second network ED99, among the plurality of antennas. Signals and/or power may be transmitted or received between the communication module ED90 and other electronic apparatuses through the selected antenna. Other components (a radio frequency integrated circuit (RFIC) or the like) besides the antenna may be included as part of the antenna module ED97.

Some of the components may be connected to each other and exchange signals (commands, data or the like) through a communication method between peripheral devices (a bus, general purpose input and output (GPIO), a serial peripheral interface (SPI), a mobile industry processor interface (MIPI), or the like).

Commands or data may be transmitted or received between the electronic apparatus ED01 and an external apparatus such as the electronic apparatus ED04 through the server ED08 connected to the second network ED99. The other electronic apparatuses ED02 and ED04 may be the same as or different from the electronic apparatus ED01. All or some of the operations of the electronic apparatus ED01 may be executed by one or more of the other electronic apparatuses ED02, ED04, and ED08. For example, when the electronic apparatus ED01 needs to perform certain functions or services, the electronic apparatus ED01 may request one or more other electronic apparatuses to perform some or all of the functions or services instead of directly executing the functions or services. One or more other electronic apparatuses that have received the request may execute an additional function or service related to the request, and may transfer results of the execution to the electronic apparatus ED01. To this end, cloud computing, distributed computing, and/or client-server computing techniques may be used.

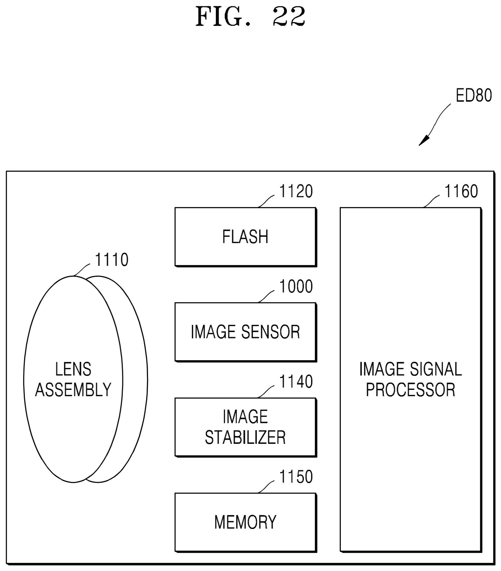

FIG. 22 is a schematic block diagram illustrating the camera module ED80 of the electronic apparatus ED01 shown in FIG. 21. Referring to FIG. 22, the camera module ED80 may include a lens assembly 1110, a flash 1120, an image sensor 1000, an image stabilizer 1140, a memory 1150 (a buffer memory or the like), and/or an image signal processor 1160. The lens assembly 1110 may collect and/or focus light emitted from an object to be photographed. The camera module ED80 may include a plurality of lens assemblies 1110, and in this case, the camera module ED80 may include a dual camera, a 360-degree camera, or a spherical camera. Some of the lens assemblies 1110 may have the same lens attributes (a viewing angle, a focal length, auto focus, F Number, optical zoom, and the like), or different lens attributes. The lens assembly 1110 may include a wide angle lens or a telescopic lens.

The flash 1120 may emit light to reinforce light emitted or reflected from a subject. The flash 1120 may emit visible light or IR light. The flash 1120 may include one or a plurality of light-emitting diodes (a red-green-blue (RGB) LED, a white LED, an infrared LED, an ultraviolet LED, and the like), and/or a xenon lamp. The image sensor 1000 may be the image sensor 1000 described with reference to FIG. 1, and may convert light emitted or reflected from the subject and transmitted through the lens assembly 1110 into electrical signals, thereby obtaining an image corresponding to the subject.

The image stabilizer 1140 may move, in response to a movement of the camera module ED80 or the electronic apparatus ED01 including the camera module ED80, one or a plurality of lenses included in the lens assembly 1110 or the image sensor 1000 in a particular direction, or may control the movement characteristics (read-out timing or the like) of the image sensor 1000, thereby compensating for a negative effect caused by the movement of the camera module ED80 or the electronic apparatus ED01. The image stabilizer 1140 may detect a movement of the camera module ED80 or the electronic apparatus ED01 by using a gyro sensor or an acceleration sensor arranged inside or outside the camera module ED80. The image stabilizer 1140 may be implemented in an optical form.

The memory 1150 may store a part or entire data of an image obtained through the image sensor 1000 for a subsequent image processing operation. For example, when a plurality of images are obtained at high speed, only low resolution images are displayed while the obtained original data (Bayer-Patterned data, high resolution data, and the like) is stored in the memory 1150. Then, the memory 1150 may be used to transmit the original data of a selected (user selection, and the like) image to the image signal processor 1160. The memory 1150 may be incorporated into the memory ED30 of the electronic apparatus ED01, or configured to be an independently operated separate memory.

The image signal processor 1160 may obtain an image from electrical signals output from the image sensor 1000. For example, the image signal processor 1160 may cooperate with the image sensor 1000 to perform image processing. In addition, the image signal processor 1160 may request the image sensor 1000 to send image data in a specific format depending on a required image data format.

In addition, the image signal processor 1160 may perform additional image processing on the image obtained through the image sensor 1000 or image data stored in the memory 1150. The image processing may include depth map generation, 3D modeling, panorama generation, feature point extraction, image synthesis, and/or image compensation (noise reduction, resolution adjustment, brightness adjustment, blurring, sharpening, softening, and the like). The image signal processor 1160 may perform control (exposure time control, read-out timing control, or the like) on components (the image sensor 1000 or the like) included in the camera module ED80.

The image processed by the image signal processor 1160 may be stored again in the memory 1150 for additional processing or may be provided to external devices (the memory ED30, the display device ED60, the electronic apparatus ED02, the electronic apparatus ED04, the server ED08, and the like) provided outside the camera module ED80. The image signal processor 1160 may be incorporated into the processor ED20, or configured to be a separate processor operated independently of the processor ED20. When the image signal processor 1160 is implemented as a processor separate from the processor ED20, the image processed by the image signal processor 1160 may undergo additional image processing by the processor ED20 and then displayed through the display device ED60.

In addition, the image signal processor 1160 may independently receive two output signals from adjacent light sensing cells provided in each pixel or sub-pixel of the image sensor 1000 and generate an automatic focus signal from a difference between the two output signals. The image signal processor 1160 may control the lens assembly 1110 to accurately apply the focus of the lens assembly 1110 on the surface of the image sensor 1000 based on the automatic focus signal.

The electronic apparatus ED01 may further include one or more additional camera modules ED80 having different attributes or functions. The additional camera modules ED80 may each include components similar to those of the camera module ED80 shown in FIG. 22, and image sensors provided in the additional camera modules ED80 may be implemented as charged coupled device (CCD) sensors and/or complementary metal oxide semiconductor (CMOS) sensors and may include one or more sensors selected from sensors having different properties such as RGB sensors, black and white (BW) sensors, IR sensors, and ultraviolet (UV) sensors. In this case, one of the camera modules ED80 may be a wide angle camera, and another may be a telescopic camera. Similarly, one of the camera modules ED80 may be a front side camera, and another may be a read side camera.

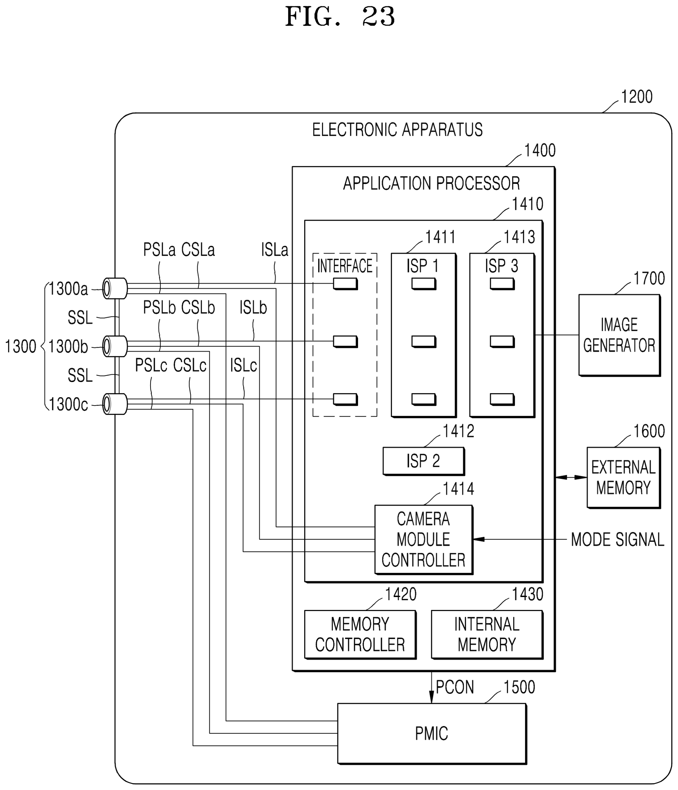

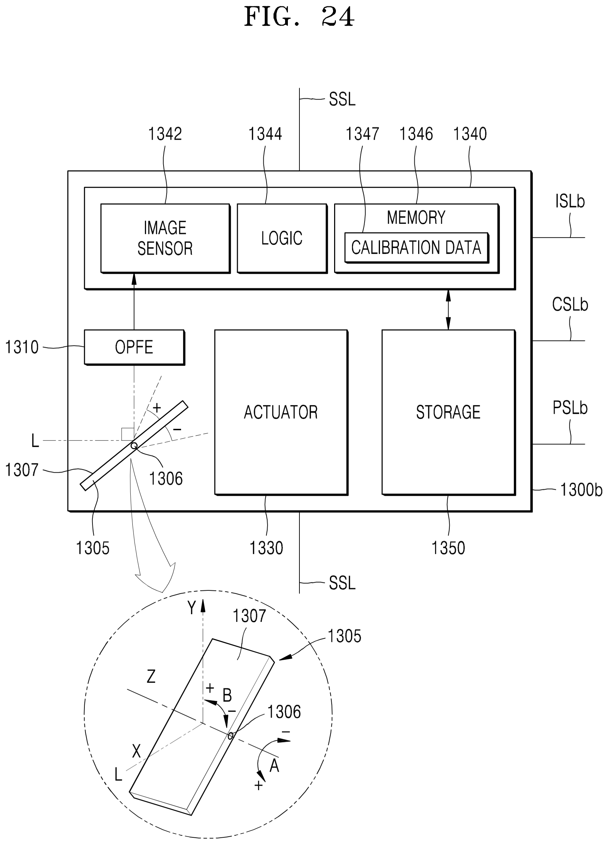

FIG. 23 is a block diagram illustrating an electronic apparatus 1200 including multiple camera modules, and FIG. 24 is a block diagram illustrating a camera module 1300b included in the electronic apparatus 1200 shown in FIG. 23.

Referring to FIG. 23, the electronic apparatus 1200 may include a camera module group 1300, an application processor 1400, a PMIC 1500, an external memory 1600, and an image generator 1700.

The camera module group 1300 may include a plurality of camera modules 1300a, 1300b, and 1300c. Although three camera modules 1300a, 1300b, and 1300c are illustrated in FIG. 23, embodiments are not limited thereto. In some embodiments, the camera module group 1300 may be modified to include only two camera modules. In some embodiments, the camera module group 1300 may be modified to include n camera modules (n refers to a natural number greater than or equal to 4).

The configuration of the camera module 1300b will be described below with reference to FIG. 24. The following description of the camera module 1300b may also be applied to the other camera modules 1300a and 1300c.

Referring to FIG. 24, the camera module 1300b may include a prism 1305, an optical path folding element (OPFE) 1310, an actuator 1330, an image sensing device 1340, and a storage 1350.

The prism 1305 may include a reflective surface 1307 of a light reflecting material and may change the path of light L incident from the outside.

In some embodiments, the prism 1305 may change the path of light L incident in a first direction (X direction) to a second direction (Y direction) perpendicular to the first direction (X direction). The prism 1305 may rotate the reflective surface 1307 of the light reflecting material in a direction A around a center shaft 1306 or rotate the center shaft 1306 in a direction B to change the path of light L incident in the first direction (X direction) to the second direction (Y direction) perpendicular to the first direction (X direction). In this case, the OPFE 1310 may move in the third direction (Z direction) that is perpendicular to both of the first direction (X direction) and the second direction (Y direction).

In some embodiments, as illustrated in FIG. 24, an A-direction maximum rotation angle of the prism 1305 may be less than or equal to 15 degrees in a positive (+) direction A and greater than 15 degrees in a negative (-) direction A. However, embodiments are not limited thereto.

In some embodiments, the prism 1305 may move by an angle of about 20 degrees or in a range from about 10 degrees to about 20 degrees or from about 15 degrees to about 20 degrees in a positive (+)or negative (-) direction B. In this case, an angle by which the prism 1305 moves in the positive (+)direction B may be the same as or similar, within a difference of about 1 degree, to an angle by which the prism 1305 moves in the negative (-) direction B.

In some embodiments, the prism 1305 may move the reflective surface 1307 of the light reflecting material in the third direction (Z direction) parallel with an extension direction of the center shaft 1306.

The OPFE 1310 may include, for example, m optical lenses where m refers to a natural number. The m optical lenses may move in the second direction (Y direction) and change an optical zoom ratio of the camera module 1300b. For example, when the default optical zoom ratio of the camera module 1300b is Z, the optical zoom ratio of the camera module 1300b may be changed to 3Z, 5Z, 10Z or greater by moving the m optical lenses included in the OPFE 1310.

The actuator 1330 may move the OPFE 1310 or the m optical lenses (hereinafter referred to as the optical lens) to a certain position. For example, the actuator 1330 may adjust the position of the optical lens such that an image sensor 1342 may be positioned at a focal length of the optical lens for accurate sensing.

The image sensing device 1340 may include the image sensor 1342, control logic 1344, and memory 1346. The image sensor 1342 may sense an image of a target by using light L provided through the optical lens. The control logic 1344 may control the overall operation of the camera module 1300b. For example, the control logic 1344 may control the operation of the camera module 1300b according to control signals provided through a control signal line CSLb.

The memory 1346 may store information, such as calibration data 1347, necessary for operations of the camera module 1300b. The calibration data 1347 may include information that is necessary for the camera module 1300b to generate image data using light L incident from the outside. For example, the calibration data 1347 may include information about the degree of rotation, information about a focal length, information about an optical axis, or the like. When the camera module 1300b is implemented as a multi-state camera that has a focal length varying with the position of the optical lens, the calibration data 1347 may include a focal length value for each position (or state) of the optical lens and information about auto focusing.

The storage 1350 may store image data sensed by the image sensor 1342. The storage 1350 may be provided outside the image sensing device 1340 and may form a stack with a sensor chip of the image sensing device 1340. In some embodiments, the storage 1350 may include electrically erasable programmable read-only memory (EEPROM). However, embodiments are not limited thereto.

Referring to FIGS. 23 and 24, in some embodiments, the camera modules 1300a, 1300b, and 1300c may respectively include actuators 1330. In this case, the camera modules 1300a, 1300b, and 1300c may include the same or different pieces of calibration data 1347 according to operations of the actuators 1330 of the camera modules 1300a, 1300b, and 1300c.

In some embodiments, one (for example, the camera module 1300b) of the camera modules 1300a, 1300b, and 1300c may be of a folded-lens type including the prism 1305 and the OPFE 1310 while the other camera modules (for example, the camera modules 1300a and 1300b) may be of a vertical type that does not include the prism 1305 and the OPFE 1310. However, embodiments are not limited thereto.

In some embodiments, one (for example, the camera module 1300c) of the camera modules 1300a, 1300b, and 1300c may include a depth camera of a vertical type that is capable of extracting depth information using infrared (IR) rays.

In some embodiments, at least two camera modules (for example, the camera modules 1300a and 1300b) among the camera modules 1300a, 1300b, and 1300c may have different fields of view. In this case, for example, the at least two camera modules (for example, the camera modules 1300a and 1300b) among the camera modules 1300a, 1300b, and 1300c may respectively have different optical lenses. However, embodiments are not limited thereto.

In some embodiments, the camera modules 1300a, 1300b, and 1300c may have fields of view that are different from each other. In this case, the camera modules 1300a, 1300b, and 1300c may have different optical lenses. However, embodiments are not limited thereto.

In some embodiments, the camera modules 1300a, 1300b, and 1300c may be physically separated from each other. That is, instead of dividing the sensing area of one image sensor 1342 for the camera modules 1300a, 1300b, and 1300c, the camera modules 1300a, 1300b, and 1300c may respectively include independent image sensors 1342.

Referring back to FIG. 23, the application processor 1400 may include an image processing unit 1410, a memory controller 1420, and an internal memory 1430. The application processor 1400 may be implemented separately from the camera modules 1300a, 1300b, and 1300c. For example, the application processor 1400 and the camera modules 1300a, 1300b, and 1300c may be implemented in different semiconductor chips separate from each other.

The image processing unit 1410 may include a plurality of image processors 1411, 1412, and 1413, and a camera module controller 1414.

Pieces of image data respectively generated by the camera modules 1300a, 1300b, and 1300c may be provided to the image processing unit 1410 respectively through image signal lines ISLa, ISLb, and ISLc separated from each other. Such image data transmission may be performed using, for example, camera serial interface (CSI) that is based on MIPI. However, embodiments are not limited thereto.

The image data transmitted to the image processing unit 1410 may be stored in the external memory 1600 before being transferred to the image processors 1411 and 1412. The image data stored in the external memory 1600 may be provided to the image processor 1411 and/or the image processor 1412. The image processor 1411 may correct the received image data to generate a moving image. The image processor 1412 may correct the received image data to generate a still image. For example, the image processors 1411 and 1412 may perform preprocessing operations such as color correction and gamma correction on the image data.

The image processor 1411 may include sub-processors. When the number of sub-processors is equal to the number of camera modules 1300a, 1300b, and 1300c, each of the sub-processors may process image data provided by one camera module. When the number of sub-processors is less than the number of camera modules 1300a, 1300b, 1300c, at least one of the sub-processors may process image data provided by multiple camera modules through a time-sharing process. The image data processed by the image processor 1411 and/or image processor 1412 may be stored in the external memory 1600 before being transferred to the image processor 1413. The image data stored in the external memory 1600 may be transferred to the image processor 1413. The image processor 1413 may perform post-processing operations such as noise correction and sharpening correction on the image data.

The image data processed by the image processor 1413 may be provided to the image generator 1700. The image generator 1700 may generate a final image according to image generation information or a mode signal by using the image data received from the image processor 1413.

For example, according to the image generation information or the mode signal, the image generator 1700 may generate an output image by merging at least portions of pieces of image data that are respectively generated by the camera modules 1300a, 1300b, and 1300c having different fields of view. In addition, according to the image generation information or the mode signal, the image generator 1700 may generate an output image by selecting one of pieces of image data that are respectively generated by the camera modules 1300a, 1300b, and 1300c having different fields of view.

In some embodiments, the image generation information may include a zoom signal or a zoom factor. In some embodiments, the mode signal may be based on a mode selected by a user.

When the image generation information includes a zoom signal (zoom factor) and the camera modules 1300a, 1300b, and 1300c have different fields of view, the image generator 1700 may perform different operations according to the type of the zoom signal. For example, when the zoom signal is a first signal, the image generator 1700 may merge image data output from the camera module 1300a with image data output from the camera module 1300c, and may then generate an output image by using the merged image data (merged image signal) and image data that is output from the camera module 1300b and not merged with other image data. When the zoom signal is a second signal different from the first signal, the image generator 1700 may generate an output image by selecting one of the pieces of image data respectively output from the camera modules 1300a, 1300b, and 1300c, instead of merging the pieces of image data with each other. However, embodiments are not limited thereto, and a method of processing image data may be changed whenever necessary.

The camera module controller 1414 may provide a control signal to each of the camera modules 1300a, 1300b, and 1300c. Control signals generated by the camera module controller 1414 may be provided to the camera modules 1300a, 1300b, and 1300c through separate control signal lines CSLa, CSLb, and CSLc.

In some embodiments, a control signal provided from the camera module controller 1414 to each of the camera modules 1300a, 1300b, and 1300c may include mode information relating to a mode signal. The camera modules 1300a, 1300b, and 1300c may operate in a first operation mode or a second operation mode in relation with a sensing speed based on the mode information.

In the first operation mode, the camera modules 1300a, 1300b, and 1300c may generate an image signal at a first speed (for example, at a first frame rate), encode the image signal at a second speed greater than the first speed (for example, at a second frame rate greater than the first frame rate), and transmit the encoded image signal to the application processor 1400. In this case, the second speed may be less than or equal to 30 times the first speed.

The application processor 1400 may store the received image signal, that is, the encoded image signal, in the internal memory 1430 or the external memory 1600 provided outside the application processor 1400. Thereafter, the application processor 1400 may read the encoded image signal from the internal memory 1430 or the external memory 1600, decode the encoded image signal, and display image data generated based on the decoded image signal. For example, the image processors 1411 and 1412 of the image processing unit 1410 may decode the encoded image signal and may also perform image processing on the decoded image signal.

In the second operation mode, the camera modules 1300a, 1300b, and 1300c may generate an image signal at a third speed less than the first speed (for example, at a third frame rate less than the first frame rate) and may transmit the image signal to the application processor 1400. The image signal provided to the application processor 1400 may be a non-encoded image signal. The application processor 1400 may perform image processing on the image signal or store the image signal in the internal memory 1430 or the external memory 1600.

The PMIC 1500 may provide power, for example, power supply voltage, to each of the camera modules 1300a, 1300b, and 1300c. For example, under control by the application processor 1400, the PMIC 1500 may provide a first piece of power to the camera module 1300a through a power signal line PSLa, a second piece of power to the camera module 1300b through a power signal line PSLb, and a third piece of power to the camera module 1300c through a power signal line PSLc.

The PMIC 1500 may generate power corresponding to each of the camera modules 1300a, 1300b, and 1300c and adjust the level of power, in response to a power control signal PCON received from the application processor 1400. The power control signal PCON may include a power adjustment signal for each operation mode of the camera modules 1300a, 1300b, and 1300c. For example, the operation mode may include a low-power mode. In this case, the power control signal PCON may include information about a camera module to be operated in the low-power mode and information on a set power level. The same level or different levels of power may be provided to the camera modules 1300a, 1300b, and 1300c. In addition, the level of power may be dynamically varied.

The embodiments described above are summarized as follows.
(1) According to an aspect of one or more embodiments, there is provided an image sensor including a sensor substrate including a plurality of sensing elements, an intermediate layer on the sensor substrate, an etch stop layer on the intermediate layer, and a nano-optical lens array on the etch stop layer, the nano-optical lens array including a plurality of nanostructures that are configured to collect incident light in the plurality of sensing elements, wherein the etch stop layer includes a transparent conductive material.
(2) The transparent conductive material may include an amorphous transparent conductive material and a crystalline transparent conductive material.
(3) For example, the transparent conductive material may include indium zinc oxide (IZO), indium gallium zinc oxide (IGZO), zinc oxide (ZnO) doped with a dopant, or a combination thereof.
(3) According to another example, the transparent conductive material may include indium tin oxide (ITO).
(4) The etch stop layer may have a thickness of 5 nm to 50 nm.
(5) The etch stop layer may include a first etch stop layer and a second etch stop layer on the first etch stop layer, and the second etch stop layer may include indium tin oxide (ITO), indium zinc oxide (IZO), indium gallium zinc oxide (IGZO), zinc oxide (ZnO) doped with a dopant, or a combination thereof.
(6) The first etch stop layer may include aluminum oxide (Al₂O₃), hafnium oxide (HfO₂), aluminum nitride (AIN), zinc oxide (ZnO), titanium oxide (TiO₂), zirconium oxide (ZrO₂), or a combination thereof.
(7) A thickness of the intermediate layer may be greater than a thickness of the nano-optical lens array.
(8) The nano-optical lens array may further include a dielectric layer on the plurality of nanostructures, and the dielectric layer may include a first material, the plurality of nanostructures include a second material, and a refractive index of the second material is greater than a refractive index of the first material.
(9) The first material may include silicon oxide (SiO₂), hafnium oxide (HfO), or a combination thereof.
(10) The second material may include titanium oxide (TiO₂), tantalum oxide (Ta₂O₃), zinc oxide (ZnO), or a combination thereof.
(11) The image sensor may further include a color filter layer between the sensor substrate and the intermediate layer, the color filter layer including a plurality of color filters that are configured to transmit light of different colors.
(12) The intermediate layer may include a planarization layer between the color filter layer and the nano-optical lens array and a sealing layer between the planarization layer and the nano-optical lens array, wherein the planarization layer may include an organic polymer material and the sealing layer may include an inorganic material.
(13) According to another aspect of one or more embodiments, there is provided a method of manufacturing an image sensor, the method including preparing a sensor substrate including a plurality of sensing elements, providing an intermediate layer on the sensor substrate, providing an etch stop layer on the intermediate layer, providing a dielectric layer on the etch stop layer, providing a hard mask on the dielectric layer to etch a hole pattern in the dielectric layer, performing a dry etching process based on the hole pattern being provided, removing the hard mask after completing the etching of the dielectric layer, and providing a nano-optical lens array by forming a plurality of nanostructures through a chemical mechanical polishing (CMP) process, wherein the etch stop layer includes a transparent conductive material.
(14) According to yet another aspect of one or more embodiments, there is provided an electronic apparatus including an image sensor configured to convert optical images into electrical signals, and a processor configured to control operations of the image sensor, and store and output signals generated by the image sensor, wherein the image sensor includes an intermediate layer on a sensor substrate, an etch stop layer on the intermediate layer, and a nano-optical lens array on the etch stop layer, the nano-optical lens array including a plurality of nanostructures that are configured to collect incident light in the plurality of sensing elements, wherein the etch stop layer includes a transparent conductive material.

As described above, according to one or more of the embodiments described above, the image sensor, the method of manufacturing the image sensor, and the electronic apparatus including the image sensor are designed to reduce cation accumulation during etching of the dielectric layer by providing the etch stop layer including a transparent conductive material under the nano-optical lens array.

According to one or more of the embodiments described above, the image sensor, the method of manufacturing the image sensor, and the electronic apparatus including the image sensor are designed to reduce etching rate variations caused by different aspect ratios of etched holes during a manufacturing process of the nano-optical lens array, prevent holes having a relatively large aspect ratio from being over etched, and effectively reduce process costs by simplifying the manufacturing process of the nano-optical lens array.

While the image sensor, the electronic apparatus including the image sensor, and the method of manufacturing the image sensor have been described according to embodiments with reference to the accompanying drawings, it will be understood by those of ordinary skill in the art that the image sensor, the electronic apparatus including the image sensor, and the method of manufacturing the image sensor are merely examples, and various modifications and other equivalent embodiments may be made therein. Therefore, the embodiments described herein should be considered in a descriptive sense only and not for purposes of limitation. The scope of the disclosure is defined not by the above description but by the following claims, and all differences within equivalent ranges of the scope of the disclosure should be considered as being included in the scope of the disclosure.

## Claims

1. An image sensor comprising:
a sensor substrate comprising a plurality of sensing elements;
an intermediate layer on the sensor substrate;
an etch stop layer on the intermediate layer; and
a nano-optical lens array on the etch stop layer, the nano-optical lens array comprising a plurality of nanostructures that are configured to collect incident light in the plurality of sensing elements,
wherein the etch stop layer comprises a transparent conductive material.

2. The image sensor of claim 1, wherein the transparent conductive material comprises indium zinc oxide (IZO), indium gallium zinc oxide (IGZO), zinc oxide (ZnO) doped with a dopant, or a combination thereof.

3. The image sensor of claim 1, wherein transparent conductive material comprises indium tin oxide (ITO).

4. The image sensor of any preceding claim, wherein the etch stop layer has a thickness of 5 nm to 50 nm.

5. The image sensor of any preceding claim, wherein the etch stop layer comprises a first etch stop layer and a second etch stop layer on the first etch stop layer,
wherein the first etch stop layer comprises aluminum oxide (Al₂O₃), hafnium oxide (HfO₂), aluminum nitride (AIN), zinc oxide (ZnO), titanium oxide (TiO₂), zirconium oxide (ZrO₂), or a combination thereof, and
wherein the second etch stop layer comprises indium tin oxide (ITO), indium zinc oxide (IZO), indium gallium zinc oxide (IGZO), zinc oxide (ZnO) doped with a dopant, or a combination thereof.

6. The image sensor of any preceding claim, wherein a thickness of the intermediate layer is greater than a thickness of the nano-optical lens array.

7. The image sensor of any preceding claim, wherein the nano-optical lens array further comprises a dielectric layer on the plurality of nanostructures, and
wherein the dielectric layer comprises a first material, the plurality of nanostructures comprise a second material, and a refractive index of the second material is greater than a refractive index of the first material.

8. The image sensor of claim 7, wherein the first material comprises silicon oxide (SiO₂), hafnium oxide (HfO), or a combination thereof and the second material comprises titanium oxide (TiO₂), tantalum oxide (Ta₂O₃), zinc oxide (ZnO), or a combination thereof.

9. The image sensor of any preceding claim, further comprising a color filter layer between the sensor substrate and the intermediate layer, the color filter layer comprising a plurality of color filters that are configured to transmit light of different colors, and optionally wherein:
the intermediate layer comprises a planarization layer between the color filter layer and the nano-optical lens array and a sealing layer between the planarization layer and the nano-optical lens array,
the planarization layer comprises an organic polymer material, and
the sealing layer comprises an inorganic material.

10. An electronic apparatus comprising:
an image sensor according to any preceding claim configured to convert optical images into electrical signals; and
a processor configured to control operations of the image sensor, and store and output signals generated by the image sensor.

11. A method of manufacturing an image sensor, the method comprising:
preparing a sensor substrate comprising a plurality of sensing elements;
providing an intermediate layer on the sensor substrate;
providing an etch stop layer on the intermediate layer;
providing a dielectric layer on the etch stop layer;
providing a hard mask on the dielectric layer to etch a hole pattern in the dielectric layer;
performing a dry etching process based on the hole pattern being provided;
removing the hard mask after completing the etching of the dielectric layer; and
providing a nano-optical lens array by forming a plurality of nanostructures through a chemical mechanical polishing (CMP) process,
wherein the etch stop layer comprises a transparent conductive material.

12. The method of claim 11, wherein the transparent conductive material comprises indium zinc oxide (IZO), indium gallium zinc oxide (IGZO), zinc oxide (ZnO) doped with a dopant, or a combination thereof.

13. The method of claim 11, wherein the transparent conductive material comprises indium tin oxide (ITO).

14. The method of claim 11, 12 or 13, wherein the etch stop layer has a thickness of 5 nm to 50 nm.

15. The method of any of claims 11 to 14, wherein the etch stop layer comprises a first etch stop layer and a second etch stop layer on the first etch stop layer,
wherein the first etch stop layer comprises aluminum oxide (Al₂O₃), hafnium oxide (HfO₂), aluminum nitride (AIN), zinc oxide (ZnO), titanium oxide (TiO₂), zirconium oxide (ZrO₂), or a combination thereof, and
wherein the second etch stop layer comprises indium tin oxide (ITO), indium zinc oxide (IZO), indium gallium zinc oxide (IGZO), zinc oxide (ZnO) doped with a dopant, or a combination thereof.
